(19) **Europäisches Patentamt / European Patent Office / Office européen des brevets**

(11) **EP 2 084 734 B1**

(12) # EUROPÄISCHE PATENTSCHRIFT

(45) Veröffentlichungstag und Bekanntmachung des Hinweises auf die Patenterteilung:
**11.05.2011 Patentblatt 2011/19**

(51) Int Cl.:
*H01L 21/3065* (2006.01)    *B81C 1/00* (2006.01)

(21) Anmeldenummer: **07785710.0**

(22) Anmeldetag: **15.08.2007**

(86) Internationale Anmeldenummer:
**PCT/DE2007/001483**

(87) Internationale Veröffentlichungsnummer:
**WO 2008/028452 (13.03.2008 Gazette 2008/11)**

(54) **VERFAHREN ZUM PLASMAÄTZEN ZUR ERZEUGUNG POSITIVER ÄTZPROFILE IN SILIZIUMSUBSTRATEN**

PLASMA ETCHING METHOD FOR PRODUCING POSITIVE ETCHING PROFILES IN SILICON SUBSTRATES

PROCEDE DE GRAVURE PAR PLASMA POUR LA PRODUCTION DE PROFILS DE GRAVURE POSITIFS DANS DES SUBSTRATS DE SILICIUM

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **06.09.2006 DE 102006043389**

(43) Veröffentlichungstag der Anmeldung:
**05.08.2009 Patentblatt 2009/32**

(73) Patentinhaber: **Technische Universität Dresden
01062 Dresden (DE)**

(72) Erfinder:
• **RICHTER, Karola
01239 Dresden (DE)**
• **ZSCHÄTZSCH, Gerd
01159 Dresden (DE)**

(74) Vertreter: **Hempel, Hartmut
Patentanwaltskanzlei,
Jagdweg 10
01159 Dresden (DE)**

(56) Entgegenhaltungen:
**EP-A- 0 822 582      WO-A-2004/093162
US-A1- 2002 106 845**

**Beschreibung**

Die Erfindung betrifft ein Verfahren zum Plasmaätzen zur Erzeugung positiver Ätzprofile in Siliziumsubstraten mittels einer Plasmaätzanlage, deren mit einer Maske geätzten Strukturen randseitig im Bereich der Struktureingangsöffnung einen mit einem negativen Struktureingangswinkel $\alpha$ versehenen Strukturüberhang aufweisen, der zur Mitte der Struktureingangsöffnung gerichtet ist, wobei ein Ätzvorgang mit einer isotropen Atzung und einer anisotropen Ätzung in einem Zeitverhältnis Z durchgeführt wird.

Ein derartiges Verfahren ist in der Druckschrift DE 103 18 568 A1 beschrieben, wobei mit dem Verfahren sich

- Siliziumgießformen oder Siliziumprägewerkzeuge zur Herstellung von Polymerformteilen,
- mikrofluidische Bauelemente mit Kanalsystemen und Düsen,
- Bauelemente der Leistungselektronik mit Trench-Strukturen und
- Spezielle Brückenstrukturen für Bauelemente der Elektronenmikroskopie od.dgl. herstellen lassen.

Zahlreiche Bauelemente der Mikrosystemtechnik werden auf der Basis strukturierter Siliziumsubstrate hergestellt. Insbesondere betrifft das Bauelemente der Mikromechanik, Mikrofluidik und Leistungselektronik. Bei der Fertigung dieser Komponenten kommt dem Prozess der Siliziumstrukturierung eine herausragende Bedeutung zu.

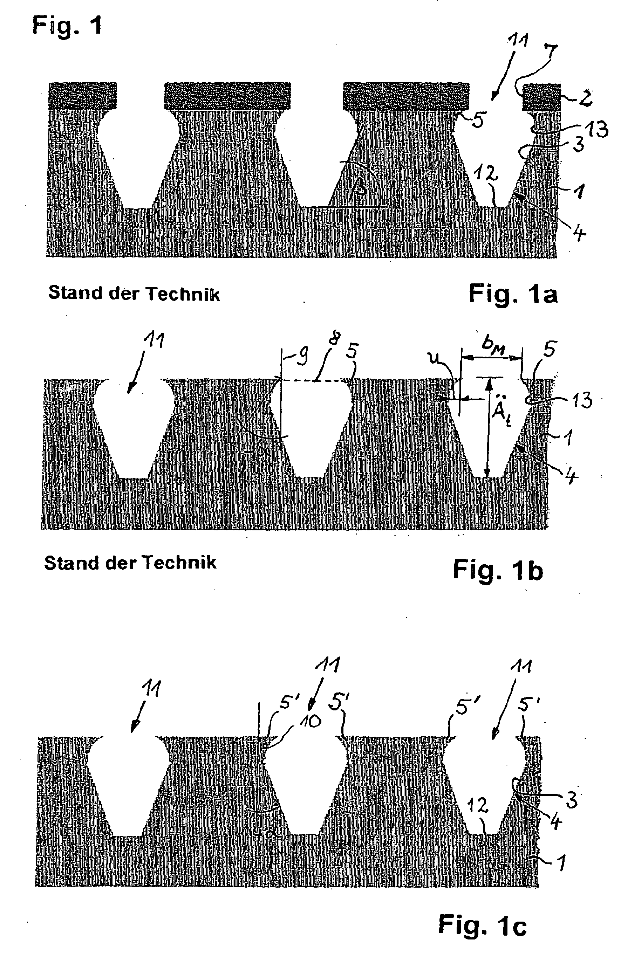

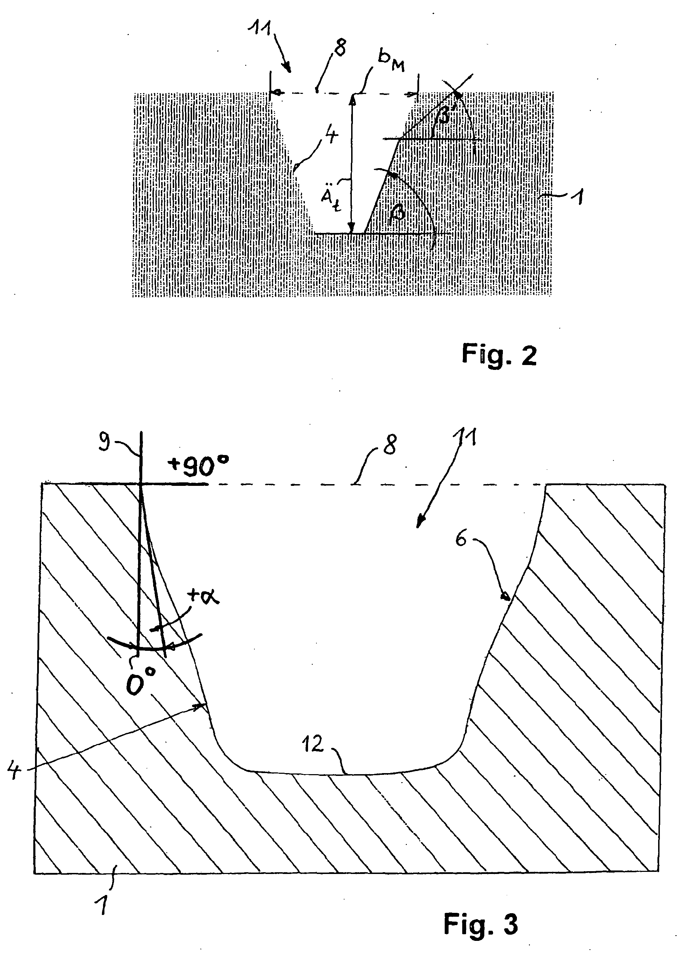

Die Fig.1, 1a, 1b sowie Fig. 2 zeigen schematisch jeweils ein angestrebtes positives Ätzprofil einer Substratstruktur mit dargestelltem positivem Böschungswinkel $\beta$ nach der Durchführung des oben angegebenen Verfahrens nach dem Stand der Technik. Dabei kann die Strukturierung des Siliziumsubstrates 1 entsprechend der Fig. 1a,1b mit einer herkömmlichen Plasmaätzanlage durchgeführt werden.

In den kommerziell erhältlichen Plasmaätzanlagen können z.B. 4"- oder 6"-SiliziumScheiben bearbeitet werden. Das Beschicken des Plasmareaktors erfolgt über eine Schleuse. Die Silizium-Scheibe wird auf einer Substratelektrode durch eine mechanische Klammerung gehalten und mittels Helium-Rückseitenkühlung gekühlt. Zur Vakuumerzeugung ist ein Pumpensystem, bestehend aus Drehschieber- und Turbomolekularpumpe vorgesehen. Der Prozessgasdruck kann im Bereich von eins bis fünfzehn Pascal eingestellt werden. Als Prozessgase lassen sich Stickstoff ($N_2$), Sauerstoff ($O_2$), Argon (Ar), Tetrafluormethan ($CF_4$), Schwefelhexafluorid ($SF_6$) und Octafluorcyclobutan ($C_4F_8$) über einen Gasein-lass zuführen. Ein Hauptbestandteil der Plasmaätzanlage ist eine hochdichte ICP-Plasmaquelle, in die eine HF-Leistung von maximal ein kW eingekoppelt werden kann. Die Substratelektrode ist biasfähig und kann mit einer HF-Leistung von maximal 300 W beaufschlagt werden. Dazu sind ein Anpassnetzwerk und ein HF-Generator vorgesehen. Die Frequenz kann in jedem Fall auf 13,56 MHz eingestellt sein. An der Plasmaätzanlage ist die Durchführung zyklischer Prozesse möglich.

Die Messung von Ätztiefen kann mit Hilfe eines Oberflächenprofilometers erfolgen.

Das herkömmliche Verfahren zur Erzeugung positiver Ätzprofile mit definiertem Böschungswinkel wird zyklisch durchgeführt. Das Verfahren setzt sich aus drei Schritten zusammen, die sich stets in der gleichen Reihenfolge wiederholen. Das Verfahren weist folgenden Ablauf auf:

Das Siliziumsubstrat 1 wird mit einer Ätzmaske 2, wie in Fig. 1a gezeigt ist, vor der Durchführung des Verfahrens versehen. Dabei kommen als Maskenmaterialien Fotoresist, thermisches Siliziumoxid ($SiO_2$), Fotoresist und $SiO_2$ kom-biniert sowie Metallmasken aus Aluminium oder Kupfer zum Einsatz.

Im ersten Schritt wird das Siliziumsubstrat 1 in einem reinen $SF_6$-Plasma isotrop geätzt. Bei diesem Ätzschritt ist die Maskenunterätzung u annähernd gleich der Ätztiefe $Ä_t$, wobei die Maskenunterätzung u eine Distanz darstellt, die sich zwischen der vertikalen Maskenkante 7 und der davon seitlich quer unter der Maske 2 vorhandenen ausgewölbten Aussparung 13 ausdehnt.

Im zweiten Schritt wird das Siliziumsubstrat 1 einem modifizierten anisotropen Prozess unterworfen. Da der anisotrope Prozess absolut senkrecht ätzt, wird die Ätztiefe $Ä_t$ vergrößert, aber die Maskenunterätzung u bleibt konstant, die Ätzfront erhält einen neuen Verlauf. Die Seitenwandungen 3 der Substratstrukturen 11 sind nach dem anisotropen Prozess mit einer Polymerschicht belegt.

Im dritten Schritt wird die Polymerschicht an den Seitenwänden 3 der Substratstruktur 11 durch eine Sauer-stoffreinigung - durch $O_2$-Plasma - entfernt und eine geätzte Substratstruktur 11, wie sie in den drei Fig.1a, Fig.1b und Fig.1c gezeigt sind, erhalten.

Die drei genannten Verfahrensschritte werden nun so oft wiederholt, bis die vorgegebene Ätztiefe $Ä_t$ erreicht ist. Durch Überlagerung der Ätzfronten, die aus den beiden Siliziumätzprozessschritten entsprechend dem isotropen Ätzschritt und dem anisotropen Ätzschritt resultieren, entstehen positive Ätzprofile 4 der Substratstrukturen 11 mit Böschungswinkeln ß zwischen 60 und 88°, wie in Fig. 1a gezeigt ist.

Eine reproduzierbare Einstellung eines vorgegebenen Böschungswinkels $\beta$ wird durch Wahl des Ätzvorganges mit einem vorgegebenen Zeitverhältnis Z für den isotropen Ätzschritt und den anisotropen Ätzschritt mittels der Gleichung

$$Z = \frac{t_{isotrop}}{t_{anisotrop}} \qquad\qquad \textbf{(I)}$$

möglich.

Je größer der zeitliche Anteil $t_{isotrop}$ der isotropen Ätzung gegenüber dem zeitlichen Anteil $t_{anisotrop}$ der aniso-tropen Ätzung im reinen SF$_6$-Plasma ist, desto kleiner wird der Böschungswinkel β. Es überwiegt also dann die Ätzung in die Querdimensionen, d.h. in die Strukturbreite $b_M$ gegenüber der Ätztiefe $\ddot{A}_t$, wie in Fig. 1b gezeigt ist.

Wenn Silizium beispielsweise in reinem SF$_6$-Plasma (SF$_6$: Schwefelhexafluorid) geätzt wird, verläuft der Prozess normalerweise isotrop, so dass die Maskenunterätzung u annähernd gleich der Ätztiefe $\ddot{A}_t$ ist,

In einer Anwendung können strukturierte Siliziumsubstrate als Gießformen zum Gießen von Bauelementen aus Polymeren oder anderen gießfähigen Substanzen eingesetzt werden. Das Ergebnis der Siliziumstrukturierung ist von entscheidender Bedeutung für die Trennbarkeit der Gussteile aus der Gießform. Wenn die Böschungswinkel β der Seitenwände 3 kleiner als 90° sind, erleichtern sie die Entnahme der geformten Gussteile wesentlich.

Ein Problem besteht aber darin, dass in bestimmten Fällen, insbesondere bei hohem Aspektverhältnis oder bei Aspektverhältnissen von Eins, bei denen die Ätztiefe $\ddot{A}_t$ annähernd gleich der Strukturbreite $b_M$ ist, nach Abschluss der ersten beiden Schritte des herkömmlichen Verfahrens unmittelbar unterhalb der Maske 2, aber noch im Oberflächenbereich des Siliziumsubstrats 1 ein Strukturüberhang 5 der Struktur 11 in Form eines überstehenden Saumes oder eines Vorsprungs, der zur Mitte der Struktureingangsöffnung 8 gerichtet ist, vorhanden ist, wie in den Fig. 1a bis 1c in einer Profildarstellung gezeigt ist. Der Strukturüberhang 5 bewirkt, dass nach Gießen oder Prägen z.B. von mikrosystemtechnischen Bauelementen die Entfernung der erstarrten Bauelemente aus den Substratstrukturen 11 heraus schwer, nicht ganz gewaltfrei oder sogar nicht möglich ist.

Der Erfindung liegt deshalb die Aufgabe zugrunde, ein Verfahren zum Plasmaätzen zur Erzeugung positiver Ätzprofile in Siliziumsubstraten anzugeben, das derart geeignet ausgebildet ist, dass die bei Ätzung mit Masken auftretenden und unmittelbar unter der Maske im Oberflächenbereich de behandelten strukturierten Siliziumsubstrate entstehenden Strukturüberhänge beseitigt werden.

Die Aufgabe der Erfindung wird mit den Merkmalen des Patentanspruchs 1 gelöst.
In dem Verfahren zum Plasmaätzen zur Erzeugung positiver Ätzprofile in Siliziumsubstraten mittels einer Plasmaätzanlage, deren mit einer Maske geätzten Strukturen randseitig im Bereich der Struktureingangsöffnung einen mit einem negativen Struktureingangswinkel α versehenen Strukturüberhang aufweisen, der zur Mitte der Struktureingangsöffnung gerichtet ist, wobei ein erster Ätzvorgang mit einer ersten isotropen Ätzung und mit einer ersten anisotropen Ätzung in einem ersten Zeitverhältnis $Z_1$ durchgeführt wird,
wird gemäß dem Kennzeichenteil des Patentanspruchs 1
an der strukturüberhangsbehafteten Substratstruktur ein maskenloser zweiter Ätzvorgang mit folgenden Schritten durchgeführt:

A) eine zweite anisotrope Ätzung des strukturüberhangsbehafteten Siliziumsubstrats mit einer sich ausbildenden Polymerschicht an den Seitenwandungen,
B) Entfernung der Polymerschicht von den Seitenwandungen mittels eines O$_2$-Plasmas,
C) eine zweite isotrope Ätzung des Siliziumsubstrats,

wobei der zweite Ätzvorgang mit einem zweiten Zeitverhältnis $Z_2$ nach Gleichung

$$Z_2 = \frac{t_{isotrop} - 2}{t_{anisotrop} - 2} \qquad\qquad \textbf{(II)} \,,$$

mit einer strukturüberhangsfreien Ätzprofiländerung verbunden, durchgeführt wird, bis zumindest ein Struktureingangswinkel α mit α = 0° im Bereich der Struktureingangsöffnung erreicht wird, wobei die Zeitdauer $t_{isotrop}$ - 2 der zweiten isotropen Ätzung und die Zeitdauer $t_{anisotrop - 2}$ der zweiten anisotropen Ätzung vorgegeben werden.

Auch können je nach Größe des Strukturüberhangs die drei Schritte A),B),C) innerhalb des zweiten Ätzvorgangs wiederholt werden.

Zur Erzeugung eines strukturierten Siliziumsubstrats können in dem ersten Ätzvorgang das Siliziumsubstrat mit einer Ätzmaske abgedeckt und die Strukturen mit dem vorgegebenen Ätzprofil im Mikrometerbereich mit Struktur-eingangsöffnung, Seitenwandungen, einer Ätztiefe $\ddot{A}_t$ sowie einer Strukturbreite $b_M$ versehen werden, wobei zur Erzeugung des Ätzprofils die Seitenwandungen mit einem definierten, auf den Ätzgrund bezogenen eingestellten Böschungswinkel β versehen und die Strukturen mit einer Ätztiefe $\ddot{A}_t$ im Mikrometerbereich erzeugt werden und ein erster Ätzvorgang mit folgenden Schritten durchgeführt wird:

a) das Siliziumsubstrat wird zunächst durch eine erste isotrope Ätzung geätzt, wobei unterhalb der Maske eine in das Siliziumsubstrat gerichtete abgeätzte ausgewölbte Aussparung als Maskenunterätzung u entsteht, wobei im Bereich der Struktureingangöffnung sich ein Strukturüberhang mit einem negativen Struktureingangswinkel α ausbildet,

b) anschließend wird die Ätztiefe $\ddot{A}_t$ durch eine erste anisotrope Ätzung mit alternierend aufeinanderfolgenden Ätz- und Polymerisationsschritten vergrößert, wobei die Maskenunterätzung u konstant bleibt und die Ätzfront einen neuen Verlauf erhält, wobei die Seitenwandungen der Substratstruktur mit einer Polymerschicht belegt werden,

c) danach die Polymerschicht von den Seitenwandungen der Substratstruktur entfernt wird, und

d) die vorangegangenen Schritte a),b),c) in der angegebenen Reihenfolge so oft wiederholt werden, bis das vorgegebene Ätzprofil der Substratstruktur erreicht ist,

wobei für den ersten Ätzvorgang ein erstes Zeitverhältnis $Z_1$ nach Gleichung

$$Z_1 = \frac{t_{isotrop-1}}{t_{anisotrop-1}} \qquad \text{(III)}$$

realisiert wird, wobei mit $t_{isotrop-1}$ die Zeitdauer der ersten isotropen Ätzung und $t_{anisotrop-1}$ die Zeitdauer der zweiten anisotropen Ätzung vorgegeben werden.

In bestimmten Anwendungen können unmittelbar nach dem ersten Ätzvorgang mit dem ersten Zeitverhältnis $Z_1$ folgende Schritte durchgeführt werden:

- die Maske wird entfernt,
- die Oberfläche des Siliziumsubstrates und der erhaltenen Substratstruktur wird gereinigt und
- der maskenlose zweite Ätzvorgang mit einem zweiten Zeitverhältnis $Z_2$ wird durchgeführt.

Die beiden die Zeitverhältnisse $Z_1,Z_2$ realisierenden Ätzvorgänge können mit $SF_6$-Plasma durchgeführt werden.

Dabei kann eine reproduzierbare Einstellung eines vorgegebenen Böschungswinkels β durch Wahl des ersten Zeitverhältnisses $Z_1$ erreicht werden.

Eine reproduzierbare Einstellung eines vorgegebenen Struktureingangswinkels α kann durch die Wahl des zweiten Zeitverhältnisses $Z_2$ erreicht werden, wobei als Struktureingangswinkel α der sich an der randseitigen Struktureingangsöffnung zwischen dem Verlauf des Ätzprofils der Substratstruktur und der Normalen des Siliziumsubstrats ausbildende Winkel definiert wird.

Das zweite Zeitverhältnis $Z_2$ kann nach Gleichung

$$Z_2 = \frac{t_{isotrop-2}}{t_{anisotrop-2}} \geq 0{,}8 \qquad \text{(IV)}$$

eingestellt werden.

Die Ätzschritte A),B),C) des zweiten Ätzvorgangs werden gegenüber den Ätzschritten a),b),c) des ersten Ätzvorgangs in umgekehrter Reihenfolge durchgeführt, nämlich die zweite anisotrope Ätzung wird vor der zweiten isotropen Ätzung durchgeführt.

Eine Nachbehandlung mit $SF_6$-Plasma kann wahlweise mit einem vorgegebenen kleineren Böschungswinkel β' mit einem aus dem ersten Zeitverhältnis $Z_1$ abgeleiteten neu eingestellten zweiten Zeitverhältnis $Z_2$ nach Gleichung

$$Z_2 = \frac{t_{isotrop-2}}{t_{anisotrop-2}} \qquad \text{(II)}$$

durchgeführt werden.

Bei einer vorgegebenen sollwertigen Ätztiefe $\ddot{A}_t$ und einer sollwertigen Strukturbreite $b_M$ in Zusammenfassung der beiden Ätzvorgänge - des maskenbehafteten Ätzvorgangs mit dem ersten Zeitverhältnis $Z_1$ und des maskenlosen

Ätzvorganges mit dem zweiten Zeitverhältnis $Z_2$- insbesondere die Zeitverhältnisanteile derart eingestellt werden, das zumindest ein Struktureingangswinkel $\alpha$ mit $\alpha$ = 0° erreicht wird.

Bei Verwendung von $SF_6$-Plasma kann vorzugsweise ein zweites Zeitverhältnis $Z_2$ mit $Z_2$ = 1,5 ... 2 realisiert werden, wobei in sicherer Form ein positiver Struktureingangswinkel $\alpha$ mit $\alpha$ > 0° erreicht wird und damit z.B. im nachfolgenden Gieß-Anwendungsverfahren erstarrte Gussteile leicht und einfach aus der Substratstruktur lösbar sind.

Die Erfindung ermöglicht es auch, dass die durch den maskenbehafteten ersten Ätzvorgang erreichte Rauhigkeit der Seitenwandungen durch den maskenlosen zweiten Ätzvorgang beibehalten und noch verringert werden kann.

Das erfindungsgemäße Verfahren ist ein Plasmaätzprozess, mit dem sich Siliziumsubstrate so strukturieren lassen, dass dabei vorgegebene positive Ätzprofile erreicht und die maskenbedingten Struktürübefiänge vermieden werden. Der dominante Böschungswinkel der Seitenwandungen der geätzten Substratstrukturen lässt sich im Bereich zwischen 60 und 88° durch geeignete Wahl der Prozessparameter definiert einstellen. In Abhängigkeit vom Aspektverhältnis, geöffneter (d.h. zu ätzender) Fläche und eingestellten Parametern der Ätzvorgänge können Ätzraten von 3...5 $\mu$m/min und Ätztiefen bis zu mehreren Millimetern erzielt werden.

Die Erfindung wird nachfolgend anhand eines Ausführungsbeispiels mittels mehrerer Zeichnungen näher erläutert.

Es zeigen:

Fig. 1 eine Siliziumsubstratstruktur nach dem herkömmlichen Verfahren zur Erzeugung eines positiven Ätzprofils, wobei

Fig.1a das Substrat mit Substratstrukturen nach herkömmlicher Be- handlung mit einer auf dem Substrat aufgebrachten Maske mit definiertem positivem Böschungswinkel $\beta$,

Fig.1b die Substratstruktur nach Entfernung der Maske und nach Rei- nigung der Seitenwandungen des positiven Ätzprofils mit ei- nem entstandenen negativen Struktureingangswinkel - $\alpha$,

Fig.1c die Substratstruktur mit beabsichtigter Überhangbeseitigung in Richtung zu einem positiven Struktureingangswinkel + $\alpha$ zeigen,

Fig. 2 ein nach einem maskenlosen zweiten Ätzvorgang behandeltes Silizi- umsubstrat mit einem vorgegebenen Böschungswinkel $\beta$ und einer vorgegebenen Nachbehandlung mit einem beabsichtigten anderen Bö- schungswinkel $\beta$',

Fig. 3 eine mit dem maskenbehafteten Ätzvorgang erzeugte Substratstruktur mit erfindungsgemäßer Nachbehandlung mit einem maskenlosen zwei- ten Ätzvorgang nach Vorgabe des Ätzprofils in Fig. 1c, was die Abhän- gigkeit zwischen Ätzung und erreichbarem Struktureingangswinkel $\alpha$ im Überhangsbereich darstellt,

Fig. 4 ein Kombinations-Diagramm von Struktureingangswinkel $\alpha$ und von Rauhigkeit bezüglich des zweiten Zeitver- hältnisses $Z_2$ von zweiter i- sotroper und zweiter anisotroper Ätzung nach dem maskenlosen zwei- ten Ätzvorgang, d.h. die Beseitigung des Struktürüberhangs bei Ände- rung des Struktureingangswinkels $\alpha$ von negativen Werten zu positiven Werten in Abhängigkeit vom zweiten Zeitverhältnis $Z_2$ von zweiter i- sotroper Ätzung und zweiter anisotroper Ätzung,

Fig. 5 ein Diagramm bezüglich einer Vergrößerung der Querdimensionen/ Strukturbreite ($b_M$)- und einer Vergröße- rung der Ätztiefen($Ä_t$)- Dimensionen in Abhängigkeit vom zweiten Zeitverhältnis $Z_2$ der zwei- ten isotropen/ anisotropen Ätzung.

In dem Verfahren zum Plasmaätzen zur Erzeugung eines positiven Ätzprofils 4 in einem Siliziumsubstrat 1 wird mittels einer Plasmaätzanlage, dessen, wie in Fig. 1a gezeigt ist, mit einer Maske 2 geätzten Strukturen 11 randseitig im Bereich der Struktureingangsöffnung 8 einen mit einem negativen, in Fig. 1b gezeigten Struktureingangswinkel -$\alpha$ versehenen Struktürüberhang 5 aufweisen, der zur Mitte der Struktureingangsöffnung 8 gerichtet ist, ein erster Ätzvorgang mit einer ersten isotropen Atzung und mit einer ersten anisotropen Ätzung in einem vorgegebenen ersten Zeitver- hältnis $Z_1$ durchgeführt.

Erfindungsgemäß wird an der strukturübefiangsbehafteten Substratstruktur 11 ein maskenloser zweiter Ätzvorgang mit folgenden Schritten durchgeführt:

A) eine zweite anisotrope Ätzung des strukturüberhangsbehafteten Siliziumsubstrats 1 mit einer sich ausbildenden Polymerschicht an den Seitenwandungen 3,

B) Entfernung der Polymerschicht von den Seitenwandungen 3 mittels eines $O_2$-Plasmas und

C) eine zweite isotrope Ätzung des Siliziumsubstrats 1,

wobei der zweite Ätzvorgang mit einem zweiten Zeitverhältnis $Z_2$ nach Gleichung

$$Z_2 = \frac{t_{isotrop-2}}{t_{anisotrop-2}} \qquad\qquad \text{(II)},$$

mit einer strukturüberhangsfreien Ätzprofiländerung, wie in Fig. 3 gezeigt ist, verbunden, durchgeführt wird, bis zumindest ein Struktureingangswinkel $\alpha$ mit $\alpha = 0°$ im Bereich der Strukturengangsöffnung 8 erreicht wird, wobei die Zeitdauer $t_{isotrop-2}$ der zweiten isotropen Ätzung und die Zeitdauer $t_{anisotrop-2}$ der zweiten anisotropen Ätzung vorgegeben werden.

Zur Erzeugung eines strukturierten Siliziumsubstrats 1 können in einem ersten Ätzvorgang das Siliziumsubstrat 1 mit einer Maske 2 abgedeckt und die Strukturen 11 mit dem vorgegebenen Ätzprofil 4 im Mikrometerbereich mit Struktureingangsöffnung 8, Seitenwandungen 3, einer Ätztiefe $\ddot{A}_t$ sowie einer Strukturbreite $b_M$ als Querdimension versehen werden,
wobei zur Erzeugung des Ätzprofils 4 die Seitenwandungen 3 mit einem definierten, auf den Ätzgrund 12 bezogenen eingestellten Böschungswinkel $\beta$ versehen und die Strukturen 11 mit einer Ätztiefe $\ddot{A}_t$ im Mikrometerbereich erzeugt werden und
ein erster Ätzvorgang mit folgenden Schritten durchgeführt wird:

a) das Siliziumsubstrat 1 wird zunächst durch eine erste isotrope Ätzung geätzt, wobei unterhalb der Maske 2 eine in das Siliziumsubstrat 1 gerichtete abgeätzte ausgewölbte Aussparung 13 als Maskenunterätzung u entsteht, wobei im Bereich der Struktureingangsöffnung 8 sich ein Strukturüberhang 5 mit dem negativen Struktureingangswinkel $-\alpha$ ausbildet,

b) anschließend wird die Ätztiefe $\ddot{A}_t$ durch erste anisotrope Ätzung mit alternierend aufeinanderfolgenden Ätz- und Polymerisationsschritten vergrößert, wobei die Maskenunterätzung u konstant bleibt und die Ätzfront einen neuen Verlauf erhält, wobei die Seitenwandungen 3 der Substratstruktur 11 mit einer Polymerschicht belegt werden,

c) danach die Polymerschicht von den Seitenwandungen 3 der Substratstruktur 11 entfernt wird, und

d) die vorangegangenen Schritte a),b),c) in der angegebenen Reihenfolge so oft wiederholt werden, bis das vorgegebene Ätzprofil 4 der Substratstruktur 11 erreicht ist,
wobei für den ersten Ätzvorgang ein erstes Zeitverhältnis $Z_1$ nach Gleichung

$$Z_1 = \frac{t_{isotrop-1}}{t_{anisotrop-1}} \qquad\qquad \text{(III)}$$

realisiert wird, wobei mit *tisotrop-1* die Zeitdauer der ersten isotropen Ätzung und $t_{anisotrop-1}$ die Zeitdauer der ersten anisotropen Ätzung vorgegeben werden.

In bestimmten Anwendungen können unmittelbar nach dem ersten Ätzvorgang mit dem ersten Zeitverhältnis $Z_1$ folgende Schritte durchgeführt werden:

- die Maske 2 wird entfernt,
- die Oberfläche des Siliziumsubstrates 1 und der erhaltenen Substratstruktur 11 wird gereinigt und
- der maskenlose zweite Ätzvorgang mit dem zweiten Zeitverhältnis $Z_2$ wird daran angeschlossen.

Wesentlich ist, dass nach der Maskenentfernung und vor dem zweiten Ätzvorgang die Oberfläche des Siliziumsubstrats 1 und die Substratstruktur 11 gereinigt werden.

Der maskenbehaftete erste Ätzvorgang wird zyklisch durchgeführt. Das Verfahren setzt sich aus drei Schritten a),b),c) zusammen, die sich stets in der gleichen Reihenfolge wiederholen. Eine reproduzierbare Einstellung eines vorgegebenen Böschungswinkels $\beta$ ist durch Wahl des ersten Zeitverhältnisses $Z_1$ für die Zeitdauer *tisotrop-1* der ersten isotropen Ätzung und die Zeitdauer $t_{anisotrop-1}$ der ersten anisotropen Ätzung nach Gleichung

$$Z_1 = \frac{t_{isotrop\ -\ 1}}{t_{anisotrop\ -\ 1}} \qquad\qquad \text{(III)}$$

möglich.

Je größer der zeitliche Anteil der ersten isotropen Ätzung im reinen $SF_6$-Plasma ist, desto kleiner wird der Böschungswinkel β.

In der Fig. 1a besitzt das strukturierte, mit positivem Böschungswinkel β versehene Siliziumsubstrat 1 noch die aufgebrachte Maske 2. In Fig. 1b ist die Maske 2 bereits von der Substratoberfläche abgenommen.

In Fig.1c ist der Sollwert 10 des beabsichtigt zu beseitigenden Profilüberhangs 5' mit dem zu erreichenden Struktureingangswinkel +α vor dem zweiten Ätzvorgang dargestellt, wobei als Struktureingangswinkel α der sich an der Struktureingangsöffnung 8 zwischen dem Verlauf des Ätzprofils 4 der Substratstruktur 11 und der Normalen 9 des Siliziumsubstrats 1 sich ausbildende Winkel bezeichnet wird.

Die den Strukturüberhang 5,5' beseitigende Profilkorrektur erfolgt somit mit

- einer Entfernung der Maske 2, wie in Fig.1b gezeigt ist ,
- einer nachfolgenden Reinigung der mit der Maske 2 belegten Oberfläche des Siliziumsubstrates 1 und der Seitenwandungen 3 der Substratstruktur 11,
- einer Nachbehandlung mit dem maskenlosen zweiten Ätzvorgang mit $SF_6$ - Plasma wahlweise mit der Vorgabe, ein zweites Zeitverhältnis mit einem kleineren Böschungswinkel β' festzulegen, wie in Fig.2 gezeigt ist, mit einem neu eingestellten zweiten Zeitverhältnis $Z_2$ ebenfalls nach Gleichung

$$Z_2 = \frac{t_{isotrop\ -\ 2}}{t_{anisotrop\ -\ 2}} \qquad\qquad \text{(II)} .$$

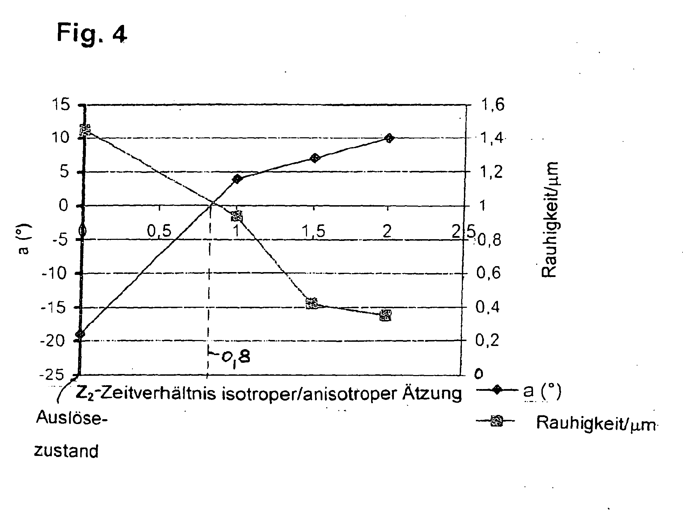

Als Ergebnis des masken losen zweiten Ätzvorgangs mit dem veränderten Zeitverhältnis $Z_2$. bei dem die isotrope Ätzung im Verhältnis zu anisotropen Ätzung länger andauert, ist bei dem maskenlosen zweiten Ätzvorgang der Strukturüberhang 5 bzw. 5' im Bereich der Struktureingangsöffnung 8 beseitigt, die sich damit vergrößert. Die Substratstrukturkorrektur, verbunden mit einer Profiländerung, ist von einem negativen Struktureingangswinkel -α aus in einen positiven Struktureingangswinkel +α erfolgt, wie ein Vergleich zwischen den Strukturen in Fig.1b, 1c (vor dem zweiten Ätzvorgang) und in Fig.3 zeigt. Wie in Fig. 4 gezeigt ist, schwenkt bei einem Zeitverhältnis $Z_2$ nach Gleichung

$$Z_2 = \frac{t_{isotrop\ -\ 2}}{t_{anisotrop\ -\ 2}} \geq 0,8 \qquad\qquad \text{(IV)}$$

insbesondere von etwa 0,8 bis 0,9, der Struktureingangswinkel α vom negativen in den positiven Bereich, und der Strukturüberhang 5 wird beseitigt, was sich in einer in Fig. 3 gezeigten, korrigierten Seitenwandung 6 äußert.

In Fig. 3 weist die Struktur 11 nach Ende des zweiten Ätzvorgangs einen positiven Struktureingangswinkel +α auf, der von der Normalen (0°) aus gemessen wird. Dabei hat sich auch die Breite $b_M$ der Struktureingangsöffnung 8 vergrößert.

In Fig. 4 ist ein Diagramm bezüglich des zweiten Zeitverhältnisses $Z_2$ von zweiter isotroper Ätzung und zweiter anisotroper Ätzung nach dem maskenlosen zweiten Ätzvorgang, d.h. die Beseitigung des Strukturüberhangs bei Änderung des Struktureingangswinkels αa von negativen Werten -α zu positiven Werten +α in Abhängigkeit vom zweiten Zeitverhältnis $Z_2$ von zweiter isotroper Ätzung und zweiter anisotroper Ätzung, sowie die Ausbildung der Rauhigkeit der Seitenwandungen in Abhängigkeit vom zweiten Zeitverhältnis $Z_2$ dargestellt, wobei bezüglich des zweiten Zeitverhältnisses $Z_2$ von zweiter isotroper Ätzung und zweiter anisotroper Ätzung nach dem masken losen zweiten Ätzvorgang die Beseitigung des Strukturüberhangs 5 bei Änderung des Struktureingangswinkels α von negativen Werten -α zu positiven Werten +α in Abhängigkeit vom Zeitverhältniswert von zweiter isotroper Ätzungsdauer $t_{isotrop\ -\ 2}$ und zweiter anisotroper Ätzungsdauer $ta_{nisotrop\ -\ 2}$ durchgeführt wird.

Für ein sicheres gewaltloses Entfernen von erstarrten Gussteilen aus den als Gießformen verwendeten, überhangskorrigierten zweiten Siliziumstrukturen 7 in Fig. 3 ist es zweckmäßig, den maskenlosen zweiten Ätzvorgang bis auf etwa ein Zeitverhältnis $Z_2$ von 1,5 bis 2, wie in Fig. 4 gezeigt ist, zu erhöhen und somit die zweite isotrope Ätzungsdauer zu verlängern oder die zweite anisotrope Ätzungsdauer zu verkürzen, so dass die zweite isotrope Ätzungsdauer deutlich größer als die zweite anisotrope Ätzungsdauer ist.

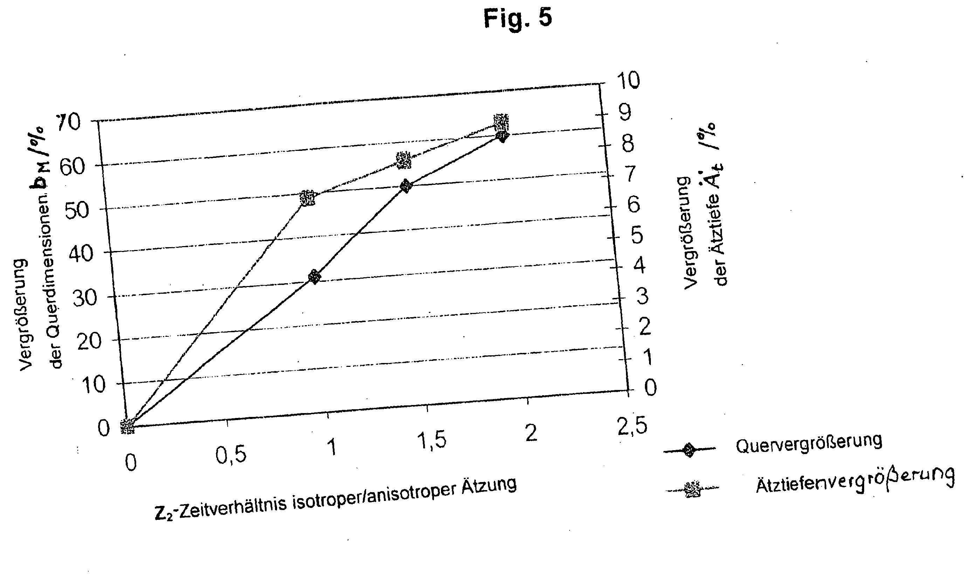

In Fig. 5 ist ein Diagramm bezüglich einer Vergrößerung der Strukturbreite ($b_M$)- und einer Vergrößerung der Ätztiefen($Ä_t$)-Dimensionen in Abhängigkeit vom zweiten Zeitverhältnis $Z_2$ der zweiten isotropen/anisotropen Ätzung dargestellt, wobei bei dem maskenlosen zweiten Ätzvorgang mit einer Vergrößerung des zweiten Zeitverhältnisses $Z_2$ auch die Ätztiefe $Ä_t$ vergrößert wird.

Bei einer vorgegebenen sollwertigen Ätztiefe $Ä_t$ und sollwertigen Strukturbreite $b_M$ ist es zweckmäßig, die Anteile der beiden Ätzvorgänge - des maskenbehafteten ersten Ätzvorgangs mit dem ersten Zeitverhältnis $Z_1$ und des maskenlosen zweiten Ätzvorgangs mit dem zweiten Zeitverhältnis $Z_2$ - insbesondere die Zeitverhältnisanteile zu berechnen und einzustellen, um die in Fig.1c beabsichtigte Beseitigung des Strukturüberhangs 5' .zu erreichen.

Es kann dann schon ausgangsseitig die Dauer der Ätzschritte mit $SF_6$-Plasma berechnet und eingestellt werden, die beim ersten Ätzvorgang als Strukturierungsprozess mit der Maske 2 erforderlich ist, und dann im Nachbehandlungsschritt festgelegt werden, damit beim masken losen zweiten Ätzvorgang der Strukturüberhang 5 beseitigt wird, wodurch dann die eingestellte Strukturbreite $b_M$ und die vorgegebene Ätztiefe $Ä_t$ der Substratstruktur 11 erreicht werden können.

Die Erfindung eröffnet die Möglichkeit, dass, wie in Fig. 5 außerdem gezeigt ist, die aus dem maskenbehafteten ersten Ätzvorgang erreichte Glätte der Seitenwandungen 3 erhalten werden kann, wobei mit dem höheren Anteil an $SF_6$-Plasma in dem zweiten isotropen Teilprozess des maskenlosen zweiten Ätzvorgangs die Rauhigkeit der Seitenwandungen 3 sogar wesentlich vermindert werden kann.

Bezugszeichenliste

| | |
|---|---|
| 1 | erstes Siliziumsubstrat |
| 2 | Maske |
| 3 | Seitenwandung |
| 4 | Substratstruktur |
| 5 | erster Strukturüberhang |
| 5' | zweiter beabsichtigter Strukturüberhang |
| 6 | korrigierte Seitenwandung |
| 7 | Maskenkante |
| 8 | Struktureingangsöffnung |
| 9 | Normale |
| 10 | Sollwert |
| 11 | Substratstruktur |
| 12 | Ätzgrund |
| 13 | Aussparung |

| | |
|---|---|
| $Ä_t$ | Ätztiefe |
| $b_M$ | Ätzbreite |
| u | Maskenunteratzung |
| $Z_1$ | Erstes Zeitverhältnis |
| $Z_2$ | Zweites Zeitverhältnis |
| $\beta$ | Erster Böschungswinkel |
| $\beta'$ | Zweiter Böschungswinkel |
| $\alpha$ | Struktureingangswinkel |
| $t_{isotrop}$-1 | Zeitdauer der ersten isotropen Ätzung |
| $t_{anisotrop\text{-}1}$ | Zeitdauer der ersten anisotropen Ätzung |
| $t_{isotrop\text{-}2}$ | Zeitdauer der zweiten isotropen Ätzung |
| $t_{anisotrop\text{-}2}$ | Zeitdauer der zweiten anisotropen Ätzung |

**Patentansprüche**

1.  Verfahren zum Plasmaätzen zur Erzeugung positiver Ätzprofile (4) in Siliziumsubstraten (1) mittels einer Plasmaätzanlage, deren mit einer Maske (2) geätzten Strukturen (11) randseitig im Bereich der Struktureingangsöffnung (8)

einen mit einem negativen Struktureingangswinkel ($\alpha$) versehenen Strukturüberhang (5) aufweisen, der zur Mitte der Struktureingangsöffnung (8) gerichtet ist, wobei ein erster Ätzvorgang mit einer ersten isotropen Atzung und mit einer ersten anisotropen Ätzung in einem vorgegebenen ersten Zeitverhältnis ($Z_1$) durchgeführt wird,
**dadurch gekennzeichnet,**
**dass** an der strukturüberhangsbehafteten Substratstruktur (11) ein maskenloser zweiter Ätzvorgang mit folgenden Schritten durchgeführt wird:

A) eine zweite anisotrope Ätzung des strukturüberhangsbehafteten Siliziumsubstrats (1) mit einer sich ausbildenden Polymerschicht an den Seitenwandungen (3),
B) Entfernung der Polymerschicht von den Seitenwandungen (3) mittels eines $O_2$-Plasmas,
C) eine zweite isotrope Ätzung des Siliziumsubstrats (1),

wobei der zweite Ätzvorgang mit einem zweiten Zeitverhältnis ($Z_2$) nach Gleichung

$$Z_2 = \frac{t_{isotrop\ -\ 2}}{t_{anisotrop\ -\ 2}} \qquad (II) ,$$

mit einer strukturüberhangsfreien Ätzprofiländerung verbunden, durchgeführt wird, bis zumindest ein Struktureingangswinkel ($\alpha$) mit $\alpha = 0°$ im Bereich der Struktureingangsöffnung (8) erreicht wird, wobei die Zeitdauer ($t_{isotrop\ -\ 2}$) der zweiten isotropen Ätzung und die Zeitdauer ($t_{anisotrop\ -\ 2}$) der zweiten anisotropen Ätzung vorgegeben werden, und wobei als Struktureingangswinkel $\alpha$ der sich an der randseitigen Struktureingangsöffnung zwischen dem Verlauf des Ätzprofils der Substratstruktur und der Normalen des Siliziumsubstrats ausbildende Wcnket definiert wird.

2. Verfahren nach Anspruch 1,
**dadurch gekennzeichnet,**
**dass** je nach Größe des Strukturüberhangs (5) die drei Schritte A),B),C) innerhalb des zweiten Ätzvorgangs wiederholt werden.

3. Verfahren nach Anspruch 1 oder 2,
**dadurch gekennzeichnet,**
**dass** im ersten Ätzvorgang das Siliziumsubstrat (1) mit einer Maske (2) abgedeckt und die Strukturen (11) mit dem vorgegebenen Ätzprofil (4) im Mikrometerbereich mit Struktureingangsöffnung (8), Seitenwandungen (3), einer Ätztiefe $Ä_t$ sowie einer Strukturbreite ($b_M$) versehen werden,
wobei zur Erzeugung des Ätzprofils (4) die Seitenwandungen (3) mit einem definierten, auf den Ätzgrund (12) bezogenen eingestellten Böschungswinkel ($\beta$) versehen und die Strukturen (11) mit einer Ätztiefe ($Ä_t$) im Mikrometerbereich erzeugt werden und
ein erster Ätzvorgang mit folgenden Schritten durchgeführt wird:

a) das Siliziumsubstrat (1) wird zunächst durch eine erste isotrope Ätzung geätzt, wobei unterhalb der Maske (2) eine in das Siliziumsubstrat (1) gerichtete abgeätzte ausgewölbte Aussparung (13) als Maskenunterätzung (u) entsteht, wobei im Bereich einer Struktureingangsöffnung (8) sich ein Strukturüberhang (5) mit einem negativen Struktureingangswinkel (-$\alpha$) ausbildet,
b) anschließend wird die Ätztiefe ($Ä_t$) durch eine erste anisotrope Ätzung mit alternierend aufeinanderfolgenden Ätz- und Polymerisationsschritten vergrößert, wobei die Maskenunterätzung (u) konstant bleibt und die Ätzfront einen neuen Verlauf erhält, wobei die Seitenwandungen (3) der Substratstruktur (11) mit einer Polymerschicht belegt werden,
c) danach die Polymerschicht von den Seitenwandungen (3) der Substratstruktur (11) entfernt wird, und
d) die vorangegangenen Schritte a),b),c) in der angegebenen Reihenfolge so oft wiederholt werden, bis das vorgegebene Ätzprofil (4) der Substratstruktur (11) erreicht ist,

wobei für den ersten Ätzvorgang ein erstes Zeitverhältnis ($Z_1$) nach Gleichung

$$Z_1 = \frac{t_{isotrop\ -\ 1}}{t_{anisotrop\ -\ 1}} \qquad\qquad \text{(I)}$$

realisiert wird, wobei mit $t_{isotrop-1}$ die Zeitdauer der ersten isotropen Ätzung und $t_{anisotrop-1}$ die Zeitdauer der ersten anisotropen Ätzung vorgegeben werden.

**4.** Verfahren nach Anspruch 1 bis 3,
**dadurch gekennzeichnet,**
**dass** zwischen dem ersten Ätzvorgang und dem zweiten Ätzvorgang nach Beendigung des ersten Ätzvorgangs

- die Maske (2) entfernt wird,
- die Oberfläche des Siliziumsubstrates (1) und der erhaltenen Substratstruktur (11) gereinigt wird und
- der maskenlose zweite Ätzvorgang mit dem zweiten Zeitverhältnis ($Z_2$) daran angeschlossen wird.

**5.** Verfahren nach Anspruch 1 bis 4,
**dadurch gekennzeichnet,**
**dass** die beiden die Zeitverhältnisse ($Z_1, Z_2$) realisierenden Ätzvorgänge mit $SF_6$-Plasma durchgeführt werden.

**6.** Verfahren nach Anspruch 1 oder 3 oder 5,
**dadurch gekennzeichnet,**
**dass** eine reproduzierbare Einstellung eines vorgegebenen Böschungswinkels ($\beta$) durch Wahl des ersten Zeitverhältnisses ($Z_1$) erreicht wird.

**7.** Verfahren nach mindestens einem vorhergehenden Anspruch,
**dadurch gekennzeichnet,**
**dass** eine reproduzierbare Einstellung eines vorgegebenen Struktureingangswinkels ($\alpha$) durch die Wahl des zweiten Zeitverhältnisses ($Z_2$) erreicht wird, wobei als Struktureingangswinkel ($\alpha$) der sich an dem Struktureingangsöffnung (8) zwischen dem Verlauf des Ätzprofils (4) der Substratstruktur (11) und der Normalen (9) des Siliziumsubstrats (1) sich ausbildende Winkel definiert wird.

**8.** Verfahren nach mindestens einem vorhergehenden Anspruch,
**dadurch gekennzeichnet,**
**dass** das zweite Zeitverhältnis ($Z_2$) nach Gleichung

$$Z_2 = \frac{t_{isotrop\ -\ 2}}{t_{anisotrop\ -\ 2}} \geq 0{,}8 \qquad\qquad \text{(IV)}$$

eingestellt wird.

**9.** Verfahren nach einem vorhergehenden Anspruch,
**dadurch gekennzeichnet,**
**dass** eine Nachbehandlung mit $SF_6$-Plasma wahlweise mit einem vorgegebenen kleineren Böschungswinkel ($\beta'$) mit einem aus dem ersten Zeitverhältnis ($Z_1$) abgeleiteten neu eingestellten Zeitverhältnis ($Z_2$) nach Gleichung

$$Z_2 = \frac{t_{isotrop\ -\ 2}}{t_{anisotrop\ -\ 2}} \qquad\qquad \text{(II)}$$

durchgeführt wird.

**10.** Verfahren nach Anspruch 1 bis 9,
**dadurch gekennzeichnet,**

**dass** bei einer vorgegebenen sollwertigen Ätztiefe ($Ä_t$) und einer sollwertigen Strukturbreite ($b_M$) in Zusammenfassung der beiden Ätzvorgänge - des maskenbehafteten Ätzvorgangs mit dem ersten Zeitverhältnis ($Z_1$) und des maskenlosen Ätzvorganges mit dem zweiten Zeitverhältnis ($Z_2$) - insbesondere die Zeitverhältnisanteile derart eingestellt werden, das zumindest ein Struktureingangswinkel ($\alpha$) mit $\alpha = 0°$ erreicht wird.

**11.** Verfahren nach einem vorhergehenden Anspruch,
**dadurch gekennzeichnet,**
**dass** bei Verwendung von $SF_6$-Plasma vorzugsweise ein Zeitverhältnis ($Z_2$) mit $Z_2 = 1,5 ... 2$ realisiert wird, wobei ein positiver Struktureingangswinkel (+$\alpha$) mit $\alpha > 0°$ erreicht und der Strukturüberhang (5) sicher beseitigt wird.

**12.** Verfahren nach Anspruch 1 bis 11,
**dadurch gekennzeichnet,**
**dass** die durch den maskenbehafteten ersten Ätzvorgang erreichte Rauhigkeit der Seitenwandungen (3) durch den maskenlosen zweiten Ätzvorgang beibehalten oder verringert wird.


**Claims**

**1.** Plasma etching method for producing positive etching profiles (4) in silicon substrates (1) by means of a plasma etching system, whose structures (11), etched with a mask (2), exhibit a structure overhang (5) with a negative structure inlet angle ($\alpha$) at the edge in the area of the structure inlet port (8), which is aligned towards the center of the structure inlet port (8), wherein an initial etching with an initial isotropic etching and an initial anisotropic etching is performed in a predetermined time ratio ($Z_1$),
**characterized in that**
a mask-less second etching is performed on the substrate structure with the structure overhang (11) in the following steps:

    A) a second anisotropic etching of the silicon substrate with the structure overhang (1) with a polymer developing on the side walls (3),
    B) removal of he polymer from the side walls (3) by means of an O2-Plasma,
    C) a second isotropic etching of the silicon substrate (1),

wherein the second etching is performed in a time ratio ($Z_2$) according to equation

$$Z_2 = \frac{t_{isotrop\ -\ 2}}{t_{anisotrop\ -\ 2}} \qquad \textbf{(II)},$$

combined with a modification of the etching profile free from structure overhang, until at least a structure inlet angle ($\alpha$) with $\alpha = 0°$ is achieved in the area of the structure inlet port (8), wherein the time ($t_{isotrop\ -\ 2}$) of the second isotropic etching and the time ($t_{anisotrop\ -\ 2}$) of the second anisotropic etching are predetermined,
and wherein the angle forming at the edge of the structure inlet port between the path of the etching profile of the substrate structure and the normal silicon substrate is defined as structure inlet angle $\alpha$.

**2.** Method according to Claim 1,
**characterized in that**,
depending on the size of the structure overhang (5) the three steps A), B), C) are repeated within the second etching.

**3.** Method according to Claim 1 or 2,
**characterized in that**,
in the initial etching the silicon substrate (1) is covered with a mask (2) and the structures (11) are furnished with the predetermined etching profile (4) in the micrometer region with structure inlet port (8), side walls (3), an etching depth $Ä_t$ as well as a structure width ($b_M$),
wherein, for the generation of the etching profile (4), the side walls (3) are furnished with a defined slope angle ($\beta$) relative to etching bottom (12) and the structures (11) are generated with an etching depth ($Ä_t$) in the micrometer region, and

an initial etching is preformed with the following steps:

a) first of all, the silicon substrate (1) is etched in an initial isotropic etching, wherein an etched, concave recess (13) is created under the mask (2) in the silicon substrate (1) as mask under etching (u), wherein a structure overhang (5) with a negative structure inlet angle ($-\alpha$) is formed in the area of the structure inlet port (8),
b) subsequently, the etching depth ($\ddot{A}_t$) is increased by an initial anisotropic etching with alternating, sequential etching and polymerization steps, wherein the mask under etching (u) remains constant and the etching front obtains a new course, wherein the side walls (3) of the substrate structure (11) are covered with a polymer,
c) thereupon the polymer is removed from the side walls (3) of the substrate structure (11), and
d) the previous steps a), b), c) are repeated in the described sequence as many times as necessary until the predetermined etching profile (4) of the substrate structure (11) is achieved,

wherein for the initial etching an initial time ratio ($Z_1$) is realized according to equation

$$Z_1 = \frac{t_{isotrop - 1}}{t_{anisotrop - 1}} \qquad (I),$$

wherein $t_{isotrop-1}$ represents the interval duration of the initial isotropic etching and $t_{anisotrop-1}$ represents the interval duration of the initial anisotropic etching.

4. Method according to Claim 1 to 3,
**characterized in that**,
between he initial etching and the second etching, after completion of the initial etching

- the mask (2) is removed,
- the surface of the silicon substrate (1) and the obtained substrate structure (11) are cleaned, and
- the mask-less second etching with the second time ratio ($Z_2$) is performed consecutively.

5. Method according to Claim 1 to 4,
**characterized in that**,
the two etchings realizing the time ratios ($Z_1,Z_2$) are performed with $SF_6$-plasma.

6. Method according to Claim 1 or 3 or 5,
**characterized in that**,
a reproducible setting of a predetermined slope angle ($\beta$) is achieved by the selection of the initial time ratio ($Z_1$).

7. Method according to at least one of the above claims,
**characterized in that**,
a reproducible setting of a predetermined structure inlet angle ($\alpha$) is achieved by the selection of the second time ratio ($Z_2$), wherein the angle forming at the structure inlet port (8) between the course of the etching profile (4) of the substrate structure (11) and the normal (9) of the silicon substrate (1) is defined as structure inlet angle ($\alpha$).

8. Method according to at least one of the above claims,
**characterized in that**,
the second time ratio ($Z_2$) is set according to equation

$$Z_2 = \frac{t_{isotrop - 2}}{t_{anisotrop - 2}} \geq 0,8 \qquad (IV).$$

9. Method according to one of the above claims,
**characterized in that**,
a post treatment with $SF_6$-plasma is performed selectively with a predetermined smaller slope angle ($\beta'$) with a

readjusted time ratio ($Z_2$) derived from the initial time ratio ($Z_1$) according to equation

$$Z_2 = \frac{t_{isotrop} - 2}{t_{anisotrop} - 2} \qquad \text{(II)}.$$

**10.** Method according to Claim 1 to 9,
**characterized in that**,
given a predetermined nominal value etching depth ($Ä_t$) and a nominal value structure width ($b_M$) in combination of the two etchings - the mask etching with the initial time ratio ($Z_1$) and the mask-less etching with the second time ratio ($Z_2$) - particularly the time ratio are adjusted in such a way that at least a structure inlet angle ($\alpha$) of $\alpha = 0°$ is achieved.

**11.** Method according to one of the above claims,
**characterized in that**,
with the use of $SF_6$-plasma, preferably a time ratio ($Z_2$) of $Z_2 = 1,5 ... 2$ is realized, wherein a positive structure inlet angle ($+\alpha$) of $\alpha > 0°$ is achieved and the structure overhang (5) is securely eliminated.

**12.** Method according to Claims 1 to 11,
**characterized in that**,
the roughness of the side walls (3) achieved in the initial mask etching is maintained or reduced in the mask-less second etching.

**Revendications**

**1.** Procédé de gravure par plasma pour la production de profils de gravure (4) dans des substrats de silicium (1) positifs à l'aide d'une installation de gravure par plasma dont les structures (11) gravées avec un masque (2) comportent du côté du bord dans la zone d'ouverture d'entrée de la structure (8) un porte-à-faux de structure (5) pourvu d'un angle d'entrée d'ouverture ($\alpha$) qui est dirigé vers le centre de l'ouverture d'entrée de la structure (8), un premier processus de gravure étant réalisé avec une première gravure isotrope et avec une première gravure anisotrope dans un premier rapport de temps ($Z_1$),
**caractérisé en ce que**
à la structure de substrats (11) comportant des porte-à-faux de structure, on réalise un deuxième processus de gravure sans masque avec les étapes suivantes:

A) une deuxième gravure anisotrope du substrat de silicium (1) comportant des porte-à-faux de structure avec une couche polymère se formant sur les parois latérales (3),
B) élimination de la couche polymère des parois latérales (3) au moyen d'un plasma d'$O_2$,
C) une deuxième gravure isotrope du substrat de silicium (1),

le deuxième processus de gravure étant réalisé avec un deuxième rapport de temps ($Z_2$) selon l'équation

$$Z_2 = \frac{t_{isotrop} - 2}{t_{anisotrop} - 2} \qquad \text{(II)},$$

relié à une modification de profil de gravure sans porte-à-faux de structure, jusqu'à ce qu'au moins un angle d'entrée de structure ($\alpha$) avec $\alpha = 0°$ à proximité de l'ouverture d'entrée de structure (8) soit atteint, la durée ($t_{isotop - 2}$) de la deuxième gravure isotrope et la durée ($t_{anisotrop - 2}$) de la deuxième gravure anisotrope étant prédéterminées et comme angle d'entrée d'ouverture $\alpha$, étant défini l'angle se formant à l'ouverture d'entrée de la structure du côté du bord entre le passage du profil de gravure de la structure de substrat et la normale du substrat de silicium.

**2.** Procédé selon la revendication 1,

**caractérisé en ce que**
en fonction du porte-à-faux de structures (5), les trois étapes A),B),C) se répètent dans le deuxième processus de gravure.

**3.** Procédé selon la revendication 1 ou 2,
**caractérisé en ce que**
lors du premier processus de gravure, le substrat de silicium (1) est recouvert par un masque (2) et les structures (11) sont pourvues du profil de gravure (4) prédéterminé dans la zone du micromètre avec ouverture d'entrée de structure (8), parois latérales (3), une profondeur de gravure $\ddot{A}_t$ ainsi que d'une largeur de structure ($b_M$),
pour la production du profil de gravure (4), les parois latérales (3) étant pourvues d'un angle de glissement (ß) défini réglé selon le fond à graver (12) et les structures (11) étant générées avec une profondeur de gravure ($\ddot{A}_t$) dans la zone du micromètre et
un premier processus de gravure est exécuté avec les étapes suivantes:

a) le substrat de silicium (1) est tout d'abord gravé par une première gravure isotrop; sous le masque (2) apparaissant une cavité (13) bombée décapée dirigée dans le substrat de silicium (1) comme sous-gravure de masque (u), dans la zone d'une ouverture d'entrée de structure (8) un porte-à-faux de structures (5) se formant avec un angle d'entrée de structure négatif ($-\alpha$),
b) ensuite, la profondeur de gravure ($\ddot{A}_t$) étant agrandie par une première gravure anisotrope avec étapes de gravure et de polymérisation se suivant alternativement, la sous-gravure de masque (u) restant constante et le front à graver obtenant un autre processus, les parois latérales (3) de la structures (11) étant pourvues d'une couche de polymère,
c) ensuite, la couche de polymère est enlevée des parois latérales (3) de la structure (11) et
d) les étapes précédentes a),b),c) sont répétées dans cette chronologie indiquée aussi souvent jusqu'à ce que le profil de gravure (4) prédéterminé de la structure (11) soit atteinte

pour la première gravure, un premier rapport de temps (Z1) étant réalisé selon l'équation

$$Z_1 = \frac{t_{isotrop}\ -1}{t_{anisotrop}\ -1} \qquad\qquad \text{(I)},$$

la durée de la première gravure isotrope est prédéterminée par $t_{isotrop}$-1 et la durée de la première gravure anisotrope par tanisotrop-1

**4.** Procédé selon les revendications 1 à 3,
**caractérisé en ce que**
entre la première gravure et la deuxième gravure après achèvement de la première gravure

- le masque (2) est enlevé,
- la surface du substrat de silicium (1) et la structure de substrat obtenue (11) sont nettoyées et
- la deuxième gravure sans masque suit avec le deuxième rapport de temps ($Z_2$).

**5.** Procédé selon les revendications 1 à 4,
**caractérisé en ce que**
les deux gravures réalisant les rapports de temps ($Z_1$, $Z_2$) sont effectuées avec un plasma $SF_6$.

**6.** Procédé selon la revendication 1 ou 3 ou 5,
**caractérisé en ce que**
un réglage reproductible d'un angle d'inclinaison (ß) prédéterminé est obtenu par le choix du premier rapport de temps ($Z_1$).

**7.** Procédé selon au moins une des revendications précédentes
**caractérisé en ce que**
un réglage reproductible d'un angle d'entrée de structure ($\alpha$) prédéterminé par le choix du deuxième rapport de temps ($Z_2$), comme angle d'entrée de structure ($\alpha$), l'angle se formant à l'ouverture d'entrée de structure (8) entre le passage du profil de gravure (4) de la structure de substrat (11) et les normales (9) du substrats de silicium (1).

8. Procédé selon au moins une des revendications précédentes,
   **caractérisé en ce que**
   le deuxième rapport de temps ($Z_2$) selon l'équation

$$Z_2 = \frac{t_{isotrop} - 2}{t_{anisotrop} - 2} \geq 0{,}8 \qquad \text{(IV)}.$$

9. Procédé selon une des revendications précédentes,
   **caractérisé en ce que**
   un post-traitement avec plasma est effectué avec un plasma $SF_6$ au choix avec un angle d'inclinaison moins important ($\beta'$) avec un rapport de temps ($Z_2$) redéfini découlant du premier rapport de temps ($Z_1$) selon l'équation

$$Z_2 = \frac{t_{isotrop} - 2}{t_{anisotrop} - 2} \qquad \text{(II)}.$$

10. Procédé selon les revendications 1 à 9,
    **caractérisé en ce que**
    pour une profondeur de gravure ($Ä_t$) prédéterminée à valeur prescrite et une largeur de structure ($b_M$) à valeur prescrite en regroupement des deux gravures - de la gravure avec masque avec le premier rapport de temps ($Z_1$) et de la gravure sans masque de la deuxième rapport de temps ($Z_2$) - les parts de rapport de temps en particulier sont réglées de telle façon qu'au moins un angle d'entrée de structure ($\alpha$) est obtenu à $\alpha = 0°$.

11. Procédé selon une des revendications précédentes,
    **caractérisé en ce que**
    lors de l'utilisation d'un plasma $SF_6$, on réalise de préférence un rapport de temps ($Z_2$) de $Z_2 = 1{,}5 \dots 2$, un angle d'entrée de structure ($+\alpha$) étant obtenu à $\alpha > 0°$ et le porte-à-faux de structures (5) étant supprimé de façon sûre.

12. Procédé selon l'une des revendications 1 à 11,
    **caractérisé en ce que**
    la rugosité obtenue par la première gravure avec masque des parois latérales (3) est maintenue ou diminuée par la deuxième gravure sans masque.

## Fig. 1

Stand der Technik

Fig. 1a

Stand der Technik

Fig. 1b

Fig. 1c

**Fig. 2**

**Fig. 3**

# Fig. 4

Fig. 5

Z₂-Zeitverhältnis isotroper/anisotroper Ätzung

◆ Quervergrößerung

Ätztiefenvergrößerung

EP 2 084 734 B1

**IN DER BESCHREIBUNG AUFGEFÜHRTE DOKUMENTE**

**In der Beschreibung aufgeführte Patentdokumente**

- DE 10318568 A1